# FASCICULE DE BREVET EUROPEEN

(11) **EP 2 416 859 B1**
(45) Date de publication et mention de la délivrance du brevet: **08.01.2014**
(21) Numéro de dépôt: 10714909.8
(22) Date de dépôt: 02.04.2010
(51) Int. Cl.: B01D 9/00

(54) **UTILISATION D'UN ADDITIF POUR LA CRISTALLISATION DE PROTÉINES ET PROCÉDÉ**
VERWENDUNG EINES ADDITIVS FÜR DIE KRISTALLISATION VON PROTEINEN UND VERFAHREN
USE OF ADDITIVE FOR THE CRYSTALLIZATION OF PROTEINS AND PROCESS

(30) Priorité: 06.04.2009 FR 0901678
(43) Date de publication de la demande: 15.02.2012
(73) Titulaire: Centre National de la Recherche Scientifique CNRS, 75794 Paris Cedex 16 (FR); UNIVERSITE CLAUDE BERNARD - LYON 1, 69622 Villeurbanne Cédex (FR)
(72) Inventeur: FALSON, Pierre, Guy, F-07100 Annonay (FR); COLEMAN, Anthony, William, F-69300 Caluire (FR); MATAR MERHEB, Rima, F-69001 Lyon (FR); LEYDIER, Antoine, F-30200 Bagnols sur Ceze (FR); HUCHÉ, Frédéric, F-91590 La Ferté-Alais (FR)
(74) Mandataire: Novagraaf Technologies
(86) Numéro de dépôt international: PCT/FR2010/000285
(87) Numéro de publication internationale: WO 2010/116055

(56) Documents cités:
- JONES, F. ET AL.: "Bio-Inspired Calix[4]arene Additives for Crystal Growth Modification of Inorganic Materials" CRYSTAL GROWTH & DESIGN, vol. 5, no. 6, 10 décembre 2005 (2005-12-10), pages 2336-2343, XP002563358
- CAFFREY, M.: "Membrane protein crystallization" JOURNAL OF STRUCTURAL BIOLOGY, vol. 142, 2003, pages 108-132, XP002563389
- OSHIMA T ET AL: "Selective Extraction and Recovery of Cytochrome c by Liquid-Liquid Extraction Using a Calix[6]arene Carboxylic Acid Derivative" LANGMUIR, AMERICAN CHEMICAL SOCIETY, WASHINGTON, DC, US, vol. 21, no. 16, 30 juin 2005 (2005-06-30) , pages 7280-7284, XP002502667 ISSN: 0743-7463
- MARTINEZ-ARAGON M ET AL: "Host-guest extraction of immunoglobulin G using calix[6]arenas" SEPARATION AND PURIFICATION TECHNOLOGY, ELSEVIER SCIENCE, AMSTERDAM, NL, 26 mars 2008 (2008-03-26), pages 1-6, XP002502668 ISSN: 1383-5866

## Description

### Domaine technique

La présente invention se rapporte à l'utilisation et à un procédé faisant intervenir au moins un dérivé calix[n]arènique substitué par au moins une fonction acide sur la face supérieure et au moins une chaîne aliphatique de longueur variable sur l'autre face, en tant qu'additif de cristallisation d'une molécule polaire et/ou chargée positivement.

La présente invention s'inscrit par exemple dans la production et la commercialisation de kit de cristallisation.

Dans la description ci-dessous, les références entre crochets (**[ ]**) renvoient à la liste des références présentée à la fin du texte.

### Etat de la technique

La diffraction des rayons X est la méthode la plus utilisée pour déterminer la structure spatiale des protéines à l'échelle- atomique, avec jusqu'à aujourd'hui plus de 47500 structures résolues sur un total de 55000 (source Protein Data Bank : www.rcsb.org/pdb/statisitcs).

Cette méthode nécessite d'obtenir la protéine dans un état cristallin, une étape incontournable relativement aisée à franchir pour les protéines solubles mais particulièrement difficile pour les protéines membranaires (Caffrey M. (2003) Membrane protein crystallization. J Struct Biol 142, 108-32 [1]). De fait, il y a plus de 15000 structures non redondantes de protéines solubles et seulement moins de 200 structures non redondantes de protéines membranaires.

La difficulté à cristalliser des protéines membranaires provient principalement de deux problèmes propres à ce type de protéines.

Un premier problème est la difficulté d'obtenir une population de protéines membranaires extraites et stabilisées en solution avec des détergents structuralement homogènes.

L'utilisation de détergent est nécessaire d'une part pour extraire ces protéines de leur environnement membranaire (Garavito R. M. and Ferguson-Miller S. (2001) Détergents as Tools in Membrane Biochemistry. J Biol Chem 276, 32403-6 [2]), et d'autre part pour les maintenir en solution plusieurs semaines. Cependant, ces détergents ne présentent pas les mêmes caractéristiques physico-chimiques que les lipides et donc tendent à déstabiliser la structure des domaines membranaires, ce qui est une source d'hétérogénéité structurale.

Un autre problème est que la formation de contacts protéine-protéine, nécessaires à la cristallisation de celle-ci, est nettement défavorisée dans le cas des protéines membranaires (Nollert P. (2005) Membrane protein crystallization in amphiphile phases: practical and theoretical considérations. Prog Biophys Mol Biol 88, 339-57 [3]).

Les détergents sont encore une fois en cause, car pour maintenir en solution la protéine membranaire extraite des membranes ils masquent la région lipophile de celle-ci. Cela conduit à former une couronne autour du domaine membranaire dont la taille est suffisamment grande pour empêcher les régions hydrophiles de créer les contacts protéine-protéine nécessaires à la formation et la stabilisation des cristaux.

L'intérêt pour les protéines membranaires est particulièrement grand. Elles représentent environ 30% du protéome, tous organismes confondus, et sont donc largement sous représentées dans la Protein Data Bank. Plus important encore, elles représentent chez l'homme 70% des cibles thérapeutiques (Lundstrom K. (2004) Structural genomics on membrane proteins: the MePNet approach. Curr Opin Drug Discov Devel 7, 342-6 [4]), en particulier la famille des transporteurs ABC de résistance multiples aux agents chimiothérapeutiques (Dean M., Hamon Y. and Chimini G. (2001) The human ATP-binding cassette (ABC) transporter superfamily. J Lipid Res 42, 1007-17 [5] ; Efferth T. (2003) Adenosine triphosphate-binding cassette transporter gènes in ageing and age-related diseases. Ageing Res Rev 2, 11-24 [6] ; Kim R. B. (2003) Drug transporters in HIV Therapy. Top HIV Med 11, 136-9 [7] ; Rajagopal A. and Simon S. M. (2003) Subcellular localization and activity of multidrug résistance proteins. Mol Biol Cell 14, 3389-99 [8] ; Boumendjel A., Baubichon-Cortay H., Trompier D., Perrotton T. and Di Pietro A. (2005) Anticancer multidrug résistance mediated by MRP1: recent advances in the discovery of reversal agents. Med Res Rev 25, 453-72 [9] ; Frelet A. and Klein M. (2006) Insight in eukaryotic ABC transporter function by mutation analysis. FEBS Lett 580, 1064-84 [10] ; Shirasaka Y., Onishi Y., Sakurai A., Nakagawa H., Ishikawa T. and Yamashita S. (2006) Evaluation of Human P-Glycoprotein (MDR1/ABCB1) ATPase Activity Assay Method by Comparing with in Vitro Transport Measurements: Michaelis-Menten Kinetic Analysis to Estimate the Affinity of P-Glycoprotein to Drugs. Biol Pharm Bull 29, 2465-71 [11] ; Szakacs G., Paterson J. K., Ludwig J. A., Booth-Genthe C. and Gottesman M. M. (2006) Targeting multidrug résistance in cancer. Nat Rev Drug Discov 5, 219-34 [12] ; Enokizono J., Kusuhara H., Ose A., Schinkel A. H. and Sugiyama Y. (2008) Quantitative Investigation of the Role of Breast Cancer Resistance Protein (Bcrp/Abcg2) in Limiting Brain and Testis Penetration of Xenobiotic Compounds. Drug Metab Dispos*,* dmd.107.019257 [13]).

Le document Jones f. et al. (Cristal Growth & Design, 5(6), p. 2336-2343, 2005) décrit l'utilisation d'un calix[4]arène en tant qu'additif de cristallisation de composés inorganiques.

Sur le plan pratique, il est établi que des petites molécules permettent d'améliorer la probabilité de cristallisation des protéines (McPherson A. and Cudney B. (2006) Searching for silver bullets: an alternative strategy for crystallizing macromolecules. J Struct Biol 156, 387-406 [14]). Plusieurs kits d'additifs, tels que des kits à base de détergent, sont commercialisés depuis ces dernières années, notamment par *Hampton Research* (nom commercial), ou *Jena Biosciences* (nom commercial). Ils sont visiblement d'une efficacité limitée car le nombre de protéines membranaires cristallisées n'a sensiblement pas augmenté depuis leur commercialisation.

Il existe donc un réel besoin de mettre au point des additifs promouvant la cristallisation de molécules polaires et/ou chargées positivement, notamment des protéines membranaires, palliant les défauts, inconvénients et obstacles de l'art antérieur. Il est en outre nécessaire de mettre au point un procédé efficace de cristallisation de molécules polaires et/ou chargées positivement, notamment des protéines membranaires.

### Exposé de l'invention

La présente invention répond précisément à l'ensemble des problèmes techniques et inconvénients précités de l'art antérieur en utilisant au moins un dérivé calix[n]arènique tel qu'énoncé à la revendication 1, en tant qu'additif de cristallisation d'une molécule polaire et/ou chargée positivement tel qu'énoncé à la revendication 1, et en fournissant un procédé tel qu'énoncé à la revendication 6.

On entend par « cristallisation » une opération physique consistant à isoler un produit en solution, par un passage d'un état désordonné liquide gazeux ou solide à un état ordonné solide.

On entend par « cristallisation des protéines » une méthode favorisant l'empilement ordonné dans les 3 dimensions de l'espace d'une population homogène de polymères protéiques présentant une conformation commune, et conduisant à la formation d'un cristal. Les protéines se distinguent des minéraux en ce sens qu'elles sont des polymères infiniment plus complexes, polyatomiques, composés à la fois de carbone, hydrogène, oxygène, azote et éventuellement de soufre.

On entend par « calixarène » une macromolécule cyclique formant une cavité hydrophobe.

On entend par « dérivé calix[n]arènique » un calixarène composé de n cycles arèniques.

On entend par « fonction acide » une fonction donneuse d'ion hydrogène. Par exemple, la fonction acide peut être un groupe acide carboxylique (-COOH), un groupe -(CH₂)_{y}-COOH où y est un nombre entier allant de 1 à 12 ou un acide benzoïque (-C₆H₄-COOH).

On entend par « chaîne aliphatique » une chaîne carbonée, linéaire ou ramifiée, cyclique ou acyclique, saturée ou insaturée. Par exemple, la chaîne aliphatique peut être linéaire, par exemple un groupe -(CₘH2ₘ₊₁) où m est un nombre entier allant de 1 à 12, par exemple un groupe méthyle, éthyle, propyle, butyle, pentyle, hexyle, heptyle, octyle, nonyle, decyle, undécyle, dodécyle, tetradécyl, hexadécyl ou octadécyl. La chaîne aliphatique peut également être ramifiée, par exemple, elle peut être un groupe méthylpropane, 2-méthylbutane, 2,2-méthylpropane, 2-méthylpenthane, 3-méthylpentane, 2,2-diméthylbutane, 2,3-diméthylbutane, 2-méthylhexane, 3-méthylhexane, 3-éthylpentane, 2,2-diméthylpentane, 2,3-diméthylpentane, 2,4-dimétylpentane, 2,2,3-triméthylbutane, 2-méthylheptane, 3-méthylheptane, 4-méthylheptane, 3-éthylhexane, 2,2-diméthylhexane, 3,3-diméthylhexane ou 2,3-diméthylhexane. La chaîne aliphatique peut aussi être insaturée, par exemple, elle peut être un groupe propène, pentène, hexène, heptène, octène, nonène, décène, undecène, dodecène,tetradcène, hexadecène ou octadecène ayant une ou plusieurs insaturation, indépendamment de type cis ou trans.

On entend par « additif » un composé introduit dans une solution ou un mélange et apportant une propriété spécifique.

On entend par « molécule polaire » une molécule dont les barycentres de charge positive et négative ne convergent pas. Par exemple, la molécule polaire peut être une protéine, par exemple une protéine soluble ou une protéine membranaire. Par exemple la molécule polaire peut être une protéine entière ou correspondant à des fragments ou domaines de celle-ci.

On entend par « molécule chargée positivement » une molécule présentant au moins une charge positive en solution. Par exemple, la molécule chargée positivement peut être une protéine, par exemple une protéine soluble ou une protéine membranaire. Par exemple la molécule chargée positivement peut être une protéine entière ou correspondant à des fragments ou domaines de celle-ci.

L'au moins un dérivé calix[n]arènique répond à la formule (I) suivante : 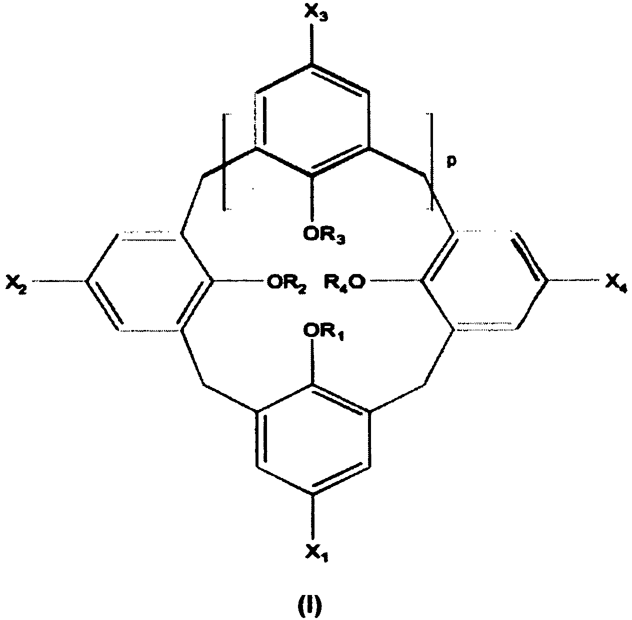 dans laquelle :
■ p est un nombre entier allant de 1 à 9 ;
■ R¹, R², R³ et R⁴ représentent, indépendamment les uns des autres, un hydrogène ou une des chaînes aliphatiques précitées. Il peut s'agir par exemple d'un groupe - (CₘH₂ₘ₊₁), linéaire ou ramifié, dans lequel m est un nombre entier allant de 1 à 12 ou valant 16 ou 18 ;
■ X¹, X², X³ et X⁴ représentent, indépendamment les uns des autres, un atome d'hydrogène ou une des fonctions acides précitées. Il peut s'agir par exemple d'un groupe carboxylique ou un groupe -(CH₂)_{y}-COOH dans lequel y est un nombre entier allant de 1 à 12.

Par exemple, l'au moins un dérivé calix[n]arènique peut répondre à la formule(I) dans laquelle :
■ p est un nombre entier égal à 1
■ un radical parmi R¹, R², R³ et R⁴ représente un groupe - (CₘH₂ₘ₊₁) linéaire ou ramifié dans lequel m est un nombre entier compris entre 1 à 12 inclus ou valant 16 ou 18 ;
■ trois radicaux parmi R¹, R², R³ et R⁴ représentent un atome d'hydrogène
;
■ un radical parmi X¹, X², X³ et X⁴ représente un atome d'hydrogène ;
■ trois radicaux parmi X¹, X², X³ ou X⁴ représentent, un groupe carboxylique ou un groupe -(CH₂)_{y}-COOH dans lequel y est un nombre entier allant de 1 à 12 ;

À titre d'exemple, selon la formule I ci-dessus, lorsque n vaut 4, p vaut 1. Si n vaut 6, p vaut 3, etc.

Le groupe - (CₘH₂ₘ₊₁) peut, par exemple, être choisi dans le groupe comprenant le groupe méthyle, éthyle, propyle, butyle, pentyle, hexyle, heptyle, octyle, nonyle, decyle, undécyle et dodécyle.

Par exemple, la molécule polaire et/ou chargée positivement peut être choisie dans le groupe comprenant les protéines, les peptides, les complexes protéiques, les domaines protéiques, les glycoprotéines, les phosphoglycoprotéines.

On entend par « protéine » un polymère linéaire d'acides aminés liés par liaison peptidique covalente.

On entend par « peptide » un polymère linéaire d'acides aminés liés de façon covalente par liaison peptidique de 2 à 100 acides aminés.

On entend par « complexes protéiques » un assemblage homo- ou hétéro-oligomériques de protéines de nature soluble ou membranaire.

On entend par « domaine protéique» un élément protéique replié dans l'espace et fonctionnel d'une protéine.

La molécule polaire et/ou chargée positivement peut, par exemple, être une protéine membranaire ou une protéine soluble, entière ou bien des fragments ou domaines de celles-ci. Les fragments ou domaines de protéines peuvent, par exemple, être produits par digestion enzymatique ménagée ou par biologie moléculaire, par exemple par recombinaison génétique.

On entend par « fragment protéique» un élément peptidique non nécessairement replié dans l'espace et fonctionnel d'une protéine.

On entend par « protéine soluble » une protéine miscible en solution aqueuse, en milieu physiologique aqueux et libre de diffusion.

On entend par « protéine membranaire » une protéine associée aux membranes biologiques soit ancrées, soit intégrales, et non libre de diffusion dans les milieux aqueux et instable dans ces milieux.

Les protéines membranaires sont souvent classées en fonction des structures qui leur permettent d'interagir avec les membranes et de la manière dont ces structures s'agencent. Les protéines membranaires peuvent être des protéines polytopiques ou des protéines monotopiques.

On entend par « protéines polytopiques » des protéines qui traversent une ou plusieurs fois la membrane.

On entend par « protéines monotopiques » des protéines qui interagissent avec un seul coté de la membrane.

Les protéines membranaires peuvent également être classées en fonction de leur difficulté à être extraite des membranes. Elles peuvent être intégrales ou périphériques.

On entend par « protéines intégrales » des protéines monotopiques ou polytopiques qui interagissent fortement avec la membrane, notamment par des interactions hydrophobes. Ces protéines sont aussi appelées « protéines intrinsèques ».

On entend par « protéines périphériques » des protéines monotopiques qui interagissent faiblement avec la membrane, c'est-à-dire soit par des liaisons électrostatiques, soit par l'intermédiaire d'autres protéines membranaires. Ces protéines sont aussi appelées « protéines extrinsèques ».

Par exemple, la protéine membranaire peut être choisie dans le groupe comprenant les récepteurs à protéines G, les canaux, les symporteurs, les antiporteurs, les transporteurs d'électrons, de protons, les pompes à anions, les pompes à cations, à métaux, à peptides, les pompes d'efflux du type BmrA. La molécule polaire et/ou chargée positivement peut également être une des différentes versions de structures primaires modifiée et/ou générée par biologie moléculaire, par exemple H₆BmrA.

Par exemple, la protéine membranaire est préalablement extraite de la membrane par des techniques d'extraction classique pour l'homme du métier.

La molécule polaire et/ou chargée positivement peut être, par exemple, toute protéine naturelle ou native, ayant ou non subit des modifications post-traductionnelles, de toute espèce ou toute protéine artificielle.

On entend par « protéine naturelle » une protéine produite par un organisme ou une cellule dont l'ADN a été modifié par recombinaison génétique.

On entend par « protéine native » une protéine à l'état fonctionnel et structuralement correctement repliée.

On entend par « modifications post-traductionnelles » des modifications effectuées à une protéine après synthèse : glycosylation, farnésylation, phosphorylation, ancre GPI, acylations, protéolyses, adressages.

Par exemple, la protéine peu être une protéine recombinante. On entend par « protéine recombinante » une protéine produite par un organisme ou une cellule dans laquelle une séquence codant pour la protéine a été introduite de manière à faire exprimer ladite protéine par cet organisme ou cette cellule.

Les espèces protéiques définies ci-dessus, peuvent être produites dans un organisme d'origine naturelle, dans un organisme hôte ou dans un système acellulaire recombinants, par synthèse chimique ou hémi-chimique.

Par exemple, la molécule polaire et/ou chargée positivement est préalablement purifiée, par exemple par chromatographie.

Dans le cas de cristallisation des protéines membranaires, le procédé de la présente invention peut, par exemple, comprendre une étape préalable d'extraction de ces protéines membranaires. Cette étape peut être une extraction classique pour l'homme du métier. Elle peut notamment comprendre l'utilisation de détergents classiques.

La mise en contact du procédé de la présente invention peut, par exemple, être réalisée à un pH compris entre 5,0 et 14,0, par exemple entre 6 et 9, comme gamme préférée plus étroite, par exemple entre 6,5 et 8,5 comme gamme préférée, par exemple à un pH égal à 8,0 comme valeur optimale.

La mise en contact du procédé de la présente invention peut, par exemple, être réalisée à une température comprise entre -40°C et 80°C, par exemple entre 4°C et 40°C, par exemple entre 15°C et 30°C, par exemple à une température de 20°C.

La mise en contact du procédé de la présente invention peut, par exemple, être réalisée à une concentration en calixarène comprise entre 1 nM et 100 mM, par exemple entre 0,1 mM et 10 mM, par exemple entre 1 et 10 mM, par exemple à une concentration égale à 1 mM.

Au détriment de toute les techniques de l'art antérieur, la présente invention permet de promouvoir, c'est-à-dire de permettre, faciliter et/ou accélérer la cristallisation de molécules polaires et/ou chargées positivement, notamment de protéines membranaires en solution ou solubles, jusque-là très difficilement cristallisables. La cristallisation notamment est améliorée grâce à la formation d'un état d'agrégation organisée des molécules polaires et/ou chargées positivement dans l'espace, conduisant à la formation de cristaux.

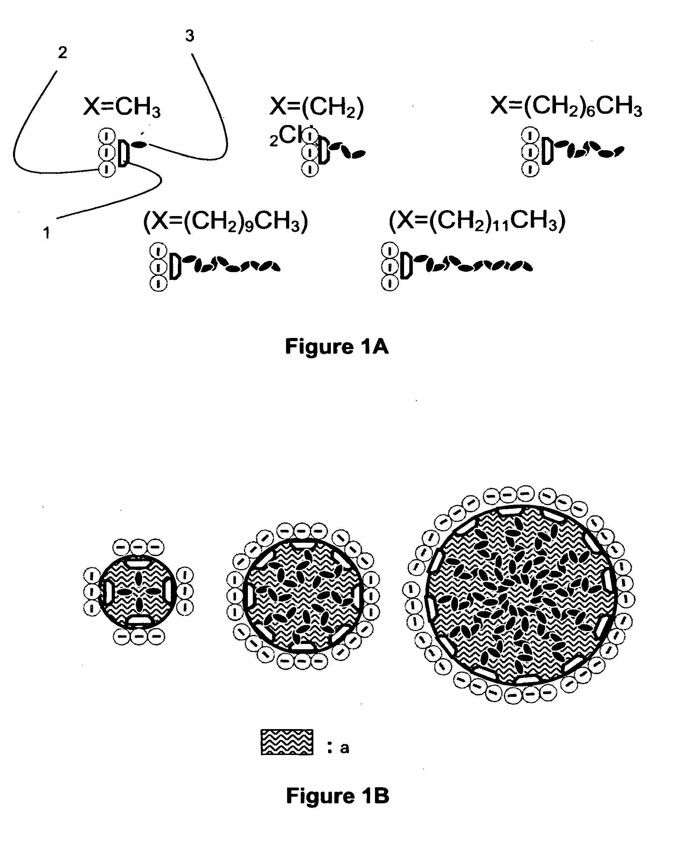

En particulier, la présente invention, permet avantageusement aux dérivés calix[n]arèniques de s'organiser de façon à générer des amas supramoléculaires exposant à leur surface les fonctions acides, maintenues par la région hydrophobe des chaînes aliphatiques, par exemple, comme illustré sur la figure 1B.

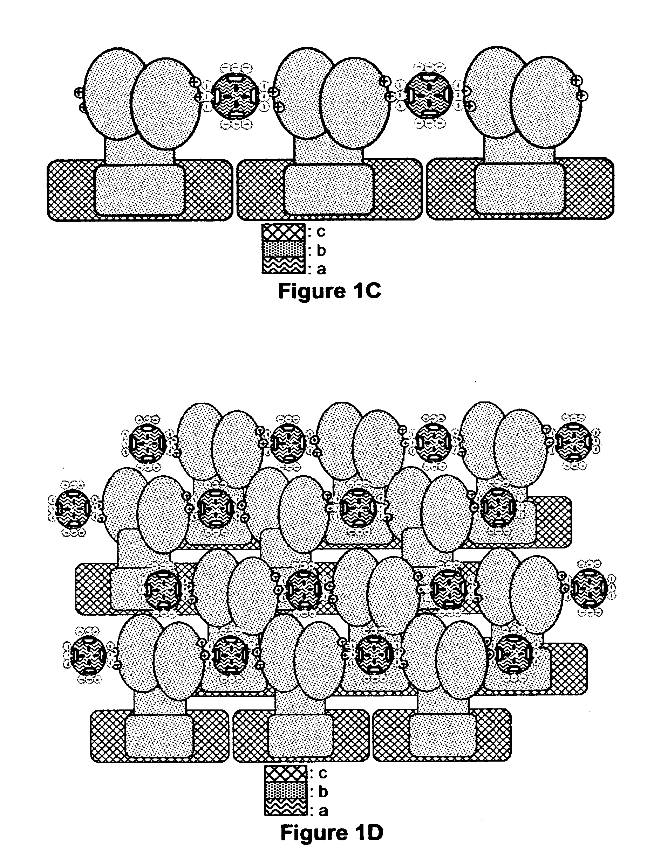

On entend par « amas supramoléculaire de dérivés calix[n]arèniques » une organisation de plusieurs dérivés calix[n]arèniques de type micellaire. Ces amas supramoléculaires s'intercalent entre les protéines membranaires par l'intermédiaire d'interactions ioniques, par exemple, comme illustré sur la figure 1C. Ces interactions permettent de renforcer la cohésion de l'édifice et en facilitent l'organisation cristalline, par exemple, comme illustré sur la figure 1D. Ces interactions s'appliquent avec la même efficacité à toutes les molécules polaires et/ou chargées positivement.

L'utilisation et le procédé de la présente invention peuvent, par exemple, faire intervenir plusieurs des dérivés calix[n]arèniques définis ci-dessus. Notamment, il peut être particulièrement avantageux d'utiliser plusieurs dérivés calix[n]arèniques de la présente invention ayant des longueurs de chaîne aliphatique différentes. Cela permet avantageusement de générer des amas supramoléculaires dont la taille dépend de la longueur des chaînes aliphatiques des dérivés calix[n]arèniques utilisés.

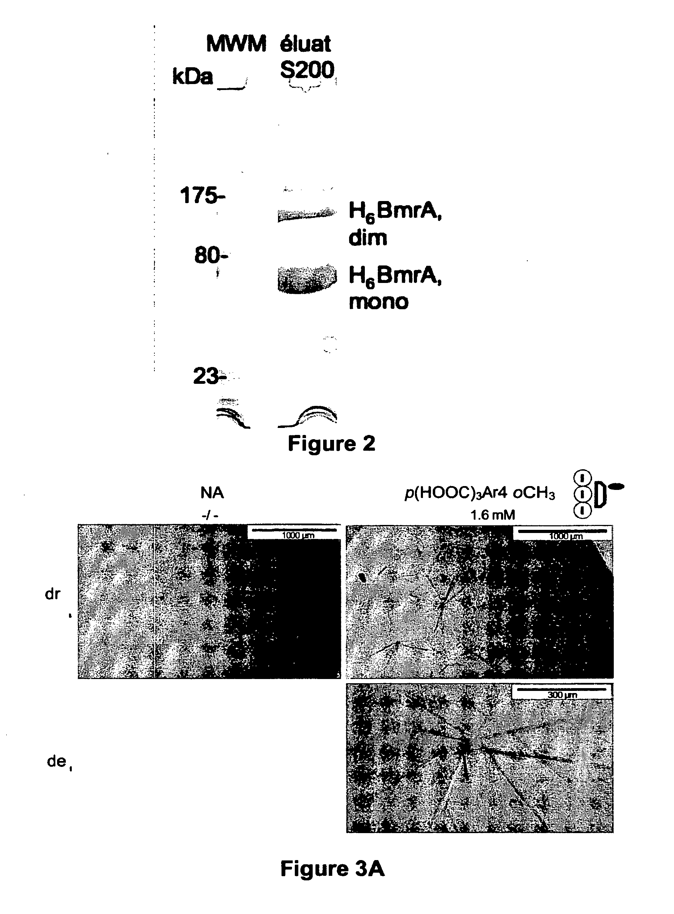

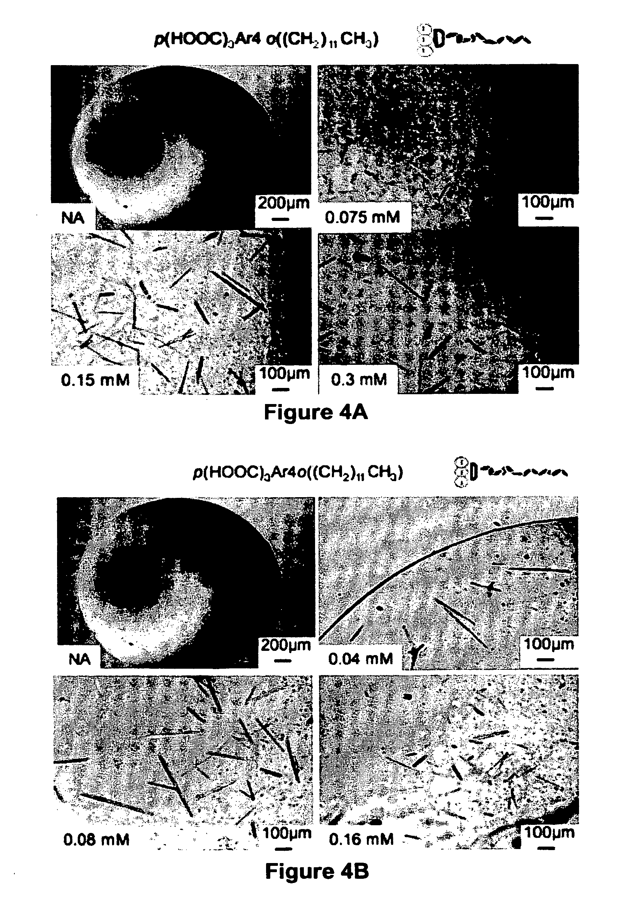

La vitesse de cristallisation de la protéine est d'autant plus rapide que la taille de la chaine aliphatique du calix[n]arène utilisé est courte (figures 3A-E). Les dérivés les plus longs favorisant de toute façon la cristallisation de la protéine plus rapidement qu'en abscence de ceux-ci (figures 4A-B).

Le fait de disposer d'amas supramoléculaires de tailles différentes permet un meilleur ajustement de ceux-ci dans les espaces vacants entre les protéines membranaires voisines. La cristallisation de protéines membranaires est grandement améliorée.

L'utilisation selon la présente invention trouve notamment une application dans la production et la commercialisation de kit de cristallisation comprenant au moins un dérivé calix[n]arènique de la présente invention. Ce kit peut, en particulier être utilisé dans des protocoles de déterminer la structure spatiale à l'échelle atomique de protéines de grand intérêt, notamment de protéines membranaires.

D'autres avantages pourront encore apparaître à l'homme du métier à la lecture des exemples ci-dessous, illustrés par les figures annexées, donnés à titre illustratif.

### Brève description des figures

- La figure 1A représente des exemples de différents calix[4]arènes, tous formés d'une couronne de 4 phénols (cycle, défini par le chiffre « 1 ») portant sur une face les groupements carboxyliques (petit tiret dans un cercle, défini par le chiffre « 2 ») et sur l'autre face, une chaîne aliphatique CₙH2ₙ₊₁, n= 1, 3, 7, 10 et 12 (petits bâtonnets, défini par le chiffre « 3 »).
- La figure 1B représente des exemples d'organisation supramoléculaire de ces molécules en amas supramoléculaires (défini par la lettre « a ») exposant les fonctions chargées (petit tiret dans un cercle) à la surface avec une cohésion maintenue par les groupements hydrophobes (petits bâtonnets) regroupés à l'intérieur de l'amas.
- La figure 1C représente un modèle d'insertion d'amas supramoléculaires, défini par la lettre « a », entre des protéines membranaires, défini par la lettre « b », dont les régions hydrophobes sont entourées d'une couronne de détergent, défini par la lettre « c ».
- La figure 1D représente un modèle d'empilement cristallin d'amas-protéines pour lequel la lettre « a » représente des amas supramoléculaires, la lettre « b » représente des protéines membranaires et la lettre « c » représente des couronnes de détergent.
- La figure 2 représente une chromatographie de H₆*B*mrA, après filtration sur gel S200, la protéine est déposée sur gel SDSPAGE 10% et coloré au bleu de Coomassie. La bande définie par « H₆BmrA, dim » correspond à la protéine H₆BmrA sous forme de dimère et la bande définie par « H₆BmrA, mono » correspond à la protéine H₆BmrA sous forme de monomère.

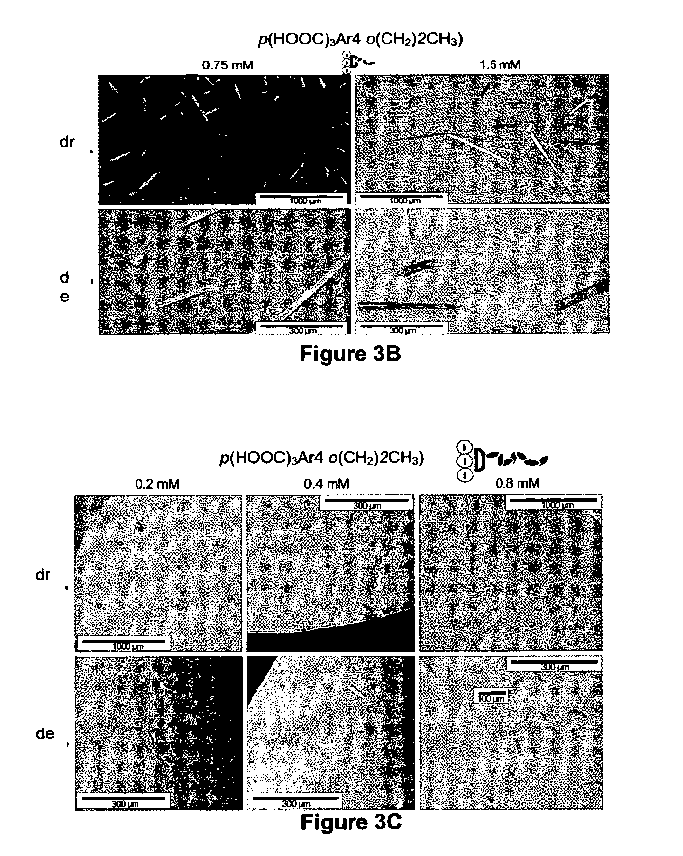

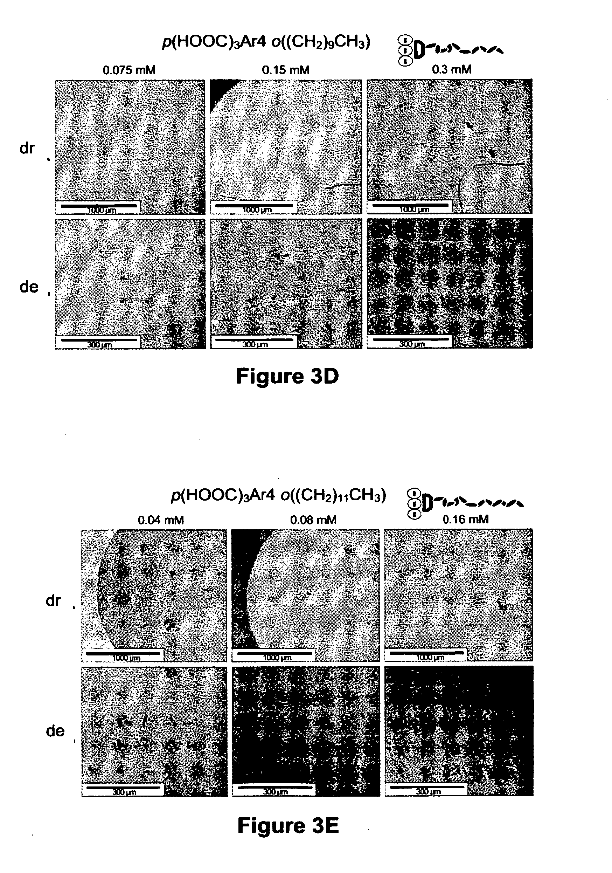

- La figure 3 représente des essais de cristallisation de H₆*B*mrA en absence ou en présence de *p*(HOOC)3Ar4 *o*X. Les concentrations utilisées sont telles qu'elles correspondent à ½x, 1x et 2x la concentration micellaire critique de chacun des composés, ceux-ci ayant un comportement surfactant.Les figures 3A à 3E représentent des gouttes « dr » et des détails de ces gouttes « de » :
   - **3A**. panneau de gauche : en absence (-/-), panneaux de droite : avec 1. 6 mM *p*(HOOC)₃Ar4 oCH₃
   - **3B**. avec 0.75 et 1.5 mM de *p*(HOOC)₃Ar4 *o*((CH₂)₂CH₃)
   - **3C**. avec 0.2, 0.4 et 0.8 mM de *p*(HOOC)₃Ar4 *o*((CH₂)₆CH₃)
   - **3D**. avec 0.075, 0.15 et 0.3 mM de *p*(HOOC)₃Ar4 *o*((CH₂)₉CH₃)
   - **3E**. avec 0.04, 0.08 et 0.16 mM de *p*(HOOC)₃Ar4 *o*((CH₂)₁₁CH₃).
- La figure 4A représente des essais de cristallisation de H₆*B*mrA en absence ou en présence de *p*(HOOC)3Ar4 oX. Les concentrations utilisées sont telles qu'elles correspondent à ½x, 1x et 2x la concentration micellaire critique de chacun des composés, ceux-ci ayant un comportement surfactant. Le panneau de gauche en haut correspond à la goutte déposée en absence de dérivé calixarènique.
   - **4A**. avec 0,075, 0,15 et 0,3 mM de *p*(HOOC)₃Ar4 *o*((CH₂)₉CH₃)
   - **4B**. avec 0,04, 0,08 et 0,16 mM de *p*(HOOC)₃Ar4 *o*((CH₂)₁₁CH₃)

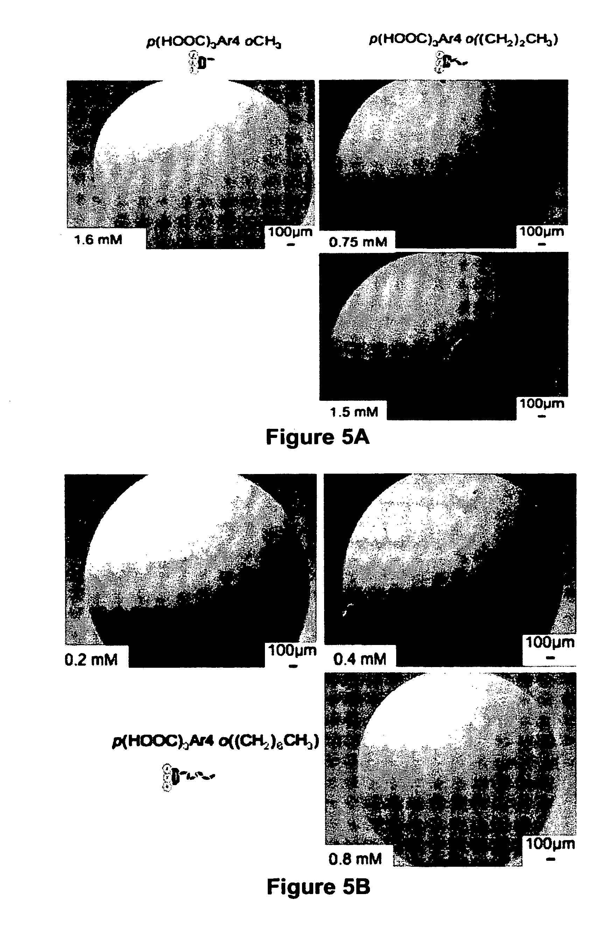

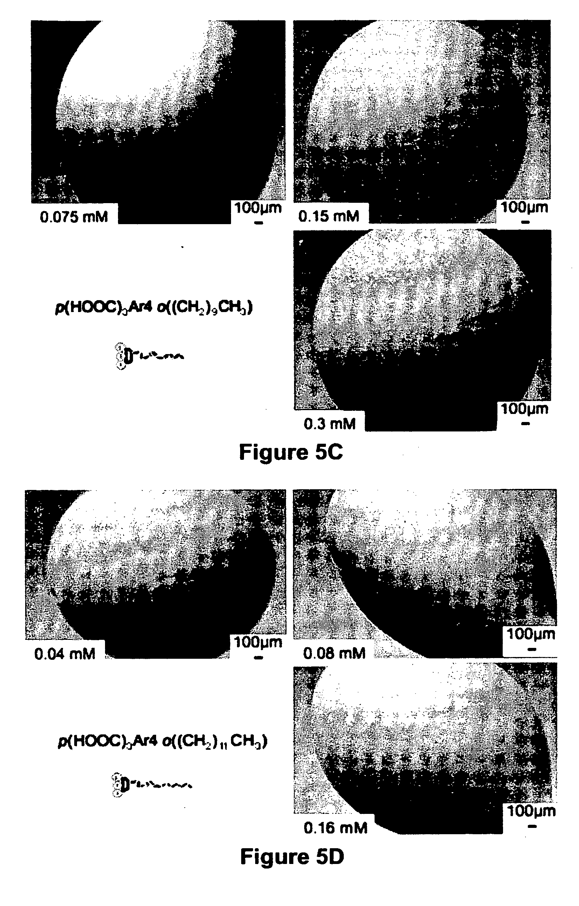

- La figure 5 représente des essais de cristallisation de H₆*B*mrA en absence de protéines et en présence de *p*(HOOC)3Ar4 *o*X. Les concentrations utilisées sont telles qu'elles correspondent à ½x, 1x et 2x la concentration micellaire critique de chacun des composés, ceux-ci ayant un comportement surfactant.
   - **5A**. panneau de gauche: avec 0.16 mM de *p*(HOOC)₃Ar4 *o*CH₃ ; panneaux de droite avec 0.75 et 1.5 mM de *p*(HOOC)₃Ar4 *o*((CH₂)₂CH₃)
   - **5B**. avec 0.2, 0.4 et 0.8 mM de *p*(HOOC)₃Ar4 *o*((CH₂)₆CH₃)
   - **5C**. avec 0.075, 0.15 et 0.3 mM de *p*(HOOC)₃Ar4 *o*((CH₂)₉CH₃)
   - **5D**. avec 0.04, 0.08 et 0.16 mM de *p*(HOOC)₃Ar4 *o*((CH₂)₁₁CH₃).

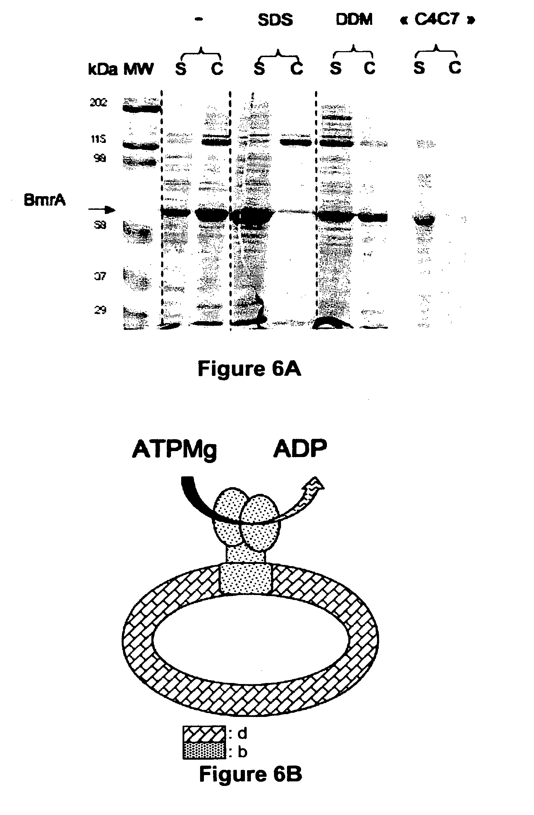

- La figure 6A une chromatographie de H₆*B*mrA, extraite soit sans détergent (-), soit avec un détergent non dénaturant de type dodécyl maltoside (DDM), soit un détergent dénaturant de type docécyl sulfate de sodium (SDS), soit un dérivé calixarènique *p*(HOOC)₃Ar4 *o*((CH₂)₆CH₃) (C4C7). Après 2 heures à 4°C, la suspension est centrifugée et le surnageant (S) et le culot (C) sont déposés sur gel SDSPAGE de 10% et coloré au bleu de Coomassie. Le surnageant est ensuite dialysé en présence de lipides pour à la fois éliminer le détergent et permettre à la protéine de retrouver un environnement lipidique, indispensable à son activité enzymatique.
- La figure 6B représente un modèle de protéine membranaire hydrolysant l'ATP en ADP en présence de magnésium (Mg), où la lettre « b » représente une protéine membranaire et la lettre « d » représente une membrane cellulaire.
- La figure 6C représente l'activité spécifique (AS) de H₆*B*mrA en µmol Pi/min/mg prot, lorsque celle-ci est extraite par soit du dodécyl maltoside (DDM), soit du docécyl sulffate de sodium (SDS), soit un dérivé calixarènique *p*(HOOC)₃Ar4 *o*((CH₂)₆CH₃) (C4C7).
- La figure 7 représente : **A.** : un cristal de H₆*B*mrA obtenu en présence de 1 mM *p*(HOOC)₃Ar4 o((CH₂)₂CH₃). **B.** et **C.** : Collection à l'ESRF ID23-2 à 0° (B) et 90° (C), des taches de diffraction obtenues à partir d'un cristal de H₆*B*mrA obtenu en présence de 1 mM *p*(HOOC)₃Ar4 o((CH₂)₂CH₃).
- La figure 8A représente des taches de diffraction obtenues à partir d'un cristal de H₆*B*mrA obtenu en présence de 1 mM *p*(HOOC)₃Ar4 *o*((CH₂)₂CH₃). La figure 8B représente un cristal de H₆*B*mrA obtenu en présence de 1 mM *p*(HOOC)₃Ar4 *o*((CH₂)₂CH₃).

### EXEMPLES

Dans ces exemples, le milieu 2TY provient de la société Bio101 (1070 Joshua Way Vista CA92083 USA), , la souche d'*Escherichia coli* BI21-DE3 provient de la société Invitrogen SARL BP 96 95613 Cergy Pontoise Cedex, l'ampicilline, l'isopropyl-beta-thio-galactoside (IPTG) et le réactif d'acide bicinchoninique (réactif BCA) proviennent de la société Sigma-Aldrich, PO Box 14508, St. Louis, MO 63178, UNITED STATES.

### Exemple 1 : Clonage, production et préparation de la protéine membranaire test H₆BmrA

### Clonage

BmrA, est un "1/2" transporteur ABC (ATP-Binding Cassette) de *Bacillus subtilis.* Il appartient à la famille des transporteurs ABC de résistance multiples aux agents chimiothérapeutiques (Chami M., Steinfels E., Orelle C., Jault J. M., Di Pietro A., Rigaud J. L. and Marco S. (2002) Three-dimensional structure by cryo-electron microscopy of YvcC, an homodimeric ATP-binding cassette transporter from Bacillus subtilis. J Mol Biol 315, 1075-85 [15]).

BmrA a été cloné en laboratoire [15] et est référencé dans la banque de données des protéines Expasy par le code O06967 (http://www.expasy.org/cgi-bin/get-sprot-entry?O06967). Sa séquence d'acides aminés est la suivante:
>tr|O06967|O06967_BACSU Putative uncharacterized protein yvcC (YvcC protein) OS=*Bacillus subtilis* GN=yvcC PE=3 SV=1

Le gène correspondant à cette séquence de BmrA a été modifié par Polymerase Chain Reaction (PCR) pour inclure à l'extrémité N-terminale une séquence MSSSHHHHHH (SEQ ID No. 2) afin de permettre la purification de la protéine par chromatographie d'affinité métal, et les sites de restriction adéquats pour introduction dans le plasmide d'expression pET23 (Novagen), en utlisant les techniques de biologie moléculaire décrites dans Molecular Cloning, a laboratory manual, second edition, Sambrook, J., Fritsch, E.F., Maniatis, T., Cold Spring Harbor Laboratory Press, New York.

### Culture / Expression

Une préculture de 200 mL de milieu 2TY, 100 µg/ml d'ampicilline est réalisée avec une souche d'*Escherichia coli* B121-DE3, fraîchement transformée avec le plasmide pET15B-His₆-BmrA.

Elle est incubée 18h à 310 K sous agitation à 200 rotations par minute (rpm). Le matin la densité de la culture OD₆₀₀ₙₘ est de 0,6. Cette préculture est utilisée pour ensemencer 6 litres du même milieu, à une OD₆₀₀ₙₘ de 0,05. Lorsque la densité optique de la culture atteint la valeur de 0,6, l'expression de His₆-BmrA est induite par addition de 0,7 mM d'IPTG, et poursuivie pendant 3 heures à 298 K.

### Fractionnement

Les bactéries sont sédimentées par centrifugation à 7 500 g pendant 10 minutes dans une centrifugeuse Beckman J2-21 pour former un culot. On élimine le surnageant, puis on met en suspension les bactéries dans 50 mM Tris-HCl (tris(hydroxyméthyl)-aminométhane chlorhydrate) pH 8,0 0,5 mM MgCl₂, 1 mM dithiothréitol (DTT), cocktail d'antiprotéase (Roche ; 1 pastille/50 ml). Trente unités/ml de Benzonase (Sigma) sont ajoutées puis les bactéries sont lysées par 2 passages successifs à la presse de French (Thermo Electron Corporation, 300 second Ave, Needham Heights, MA 02494), à 110 MPa (16 000 Psi). Dix millimolaire d'EDTA (acide éthylène-diamine-tétraacétique) est ensuite ajouté au lysat, centrifugé 30 min à 15 000 g. Le surnageant est conservé et centrifugé pendant 60 min à 200 000 g. Le culot ainsi obtenu, correspondant aux membranes et contenant la protéine membranaire d'intérêt, est suspendu dans 1,5 mL de tampon 20 mM Tris-HCl, 1 mM EDTA, 0,3 M sucrose, pour stockage.

La concentration protéique est déterminée par titration colorimétrique avec le réactif BCA (Smith P. K., Krohn R. I., Hermanson G. T., Mallia A. K., Gartner F. H., Provenzano M. D., Fujimoto E. K., Goeke N. M., Olson B. J. and Klenk D. C. (1985) Measurement of protein using bicinchoninic acid. Anal Biochem 150, 76-85 [16]). Des aliquotes de 0,5 mL (équivalent à 1 litre de culture) sont congelées et conservées dans l'azote liquide jusqu'à leur utilisation. His₆-BmrA représente environ 10 % des protéines totales et 50 % des protéines membranaires.

### Purification

Une aliquote de membrane est rapidement décongelée et dilué à 2 mg/mL de protéines dans 20 mM Tris-HCl pH 8,0, 20 mM NaCl, 0,02 mM EDTA, 0,1 mM DTT, cocktail d'antiprotéase (Roche, 1 pastille pour 100 mL). H1s₆-BmrA est extraite avec 10 mg/mL de Foscholine 12 (Anatrace, FC12) pendant 2 heures à 8°C et sous rotation lente. H₆BmrA est ensuite séparée par centrifugation pendant 1 heure à 100 000 g et 283 K.Le surnageant est passé sur colonne de 5 mL d'échange d'anions, Q-sepharose highflow (GE healthcare), préalablement nettoyée par 2 volumes de colonne (CV) avec le tampon Q_{B} (20 mM Tris-HCl pH 8.0, 1 M NaCl, 5 mg/mL FC12, cocktail d'antiprotéases: 1 pastille/100 mL), puis équilibrée avec 5 CV de tampon Q_{A} (tampon Q_{B} sans sel).

Le solubilisat est chargé à 5 mL/minute, puis la résine est lavée avec 10 CV de tampon Q_{A}. L'élution est réalisée avec un gradient linéaire (Q_{A} - Q_{B}) de NaCl (0 - 1 M) de 6 CV. La fraction contenant H₆BmrA est déposée à 5 mL/minute sur une colonne de 5 ml d'affinité-métal du type Nickel-nitriloacétique acid-agarose high trap chelating hp, (GE healthcare). La résine est préalablement équilibrée avec 3 CV de tampon Ni_{A} (20 mM Tris-HCl pH 8,0, 0,2 M NaCl, 10 mM imidazole, 5 mg/mL FC12, cocktail d'antiprotéases : 1 pastille/100 mL).

Après chargement, la résine est lavée avec 10 CV de tampon Ni_{A} puis la protéine est éluée avec un gradient linéaire d'imidazole (10 - 250 mM). Les fractions contenant H₆BmrA sont réunies et concentrées par ultrafiltration sur membrane Amicon, Ultra4 50,000 (Millipore Corporate Headquarters, 290 Concord Road, Billerica, MA 01821, USA) jusqu'à un volume de 1 mL.

Enfin, la solution est déposée sur une résine de tamis moléculaire Superdex200, 10/300 GL (GEhealthcare, Lyon, 13 - 15 rue des draperies, Les Côteaux de Saône, 69450 Saint Cyr au Mont d'Or) équilibrée avec le tampon 20 mM Tris-HCl pH 8,0, 0,1 M NaCl, 3 mg/mL FC12).

Les fractions contenant H₆BmrA sont réunies et concentrées par ultrafiltration sur membrane Amicon, Ultra4 50 000 jusqu'à une concentration de 11-12 mg/ml. La qualité de la purification est contrôlée à chaque étape par électrophorèse (figure 2) de type SDS-PAGE avec un gel de 10% acrylamide (Laemmli U. K. (1970) Cleavage of structural proteins during the assembly of the head of bacteriophage T4. Nature 227, 680-5 [17]), en préparant les échantillons protéiques comme décrit dans (Lenoir G., Menguy T., Corre F., Montigny C., Pedersen P. A., Thinès D., le Maire M. and Falson P. (2002) Overproduction in yeast and rapid and efficient purification of the rabbit SERCA1a Ca2+-ATPase. Biochim Biophys Acta 1560, 67-83 [18]).

### Exemple 2 : Cristallisation de H₆BmrA

Les essais de cristallisation de H₆BmrA sont réalisés à partir de la solution de protéine concentrée dans son tampon de gel de filtration. La solution est additionnée de 5 mM ATP, 5 mM MgCl₂, 2 mM d'orthovanadate de sodium. La concentration protéique finale est de 10 mg/mL.

Les essais sont réalisés en gouttes suspendues dans une plaque de cristallisation 24 puits de type Linbro (Hampton Research, 34 Journey, Aliso Viejo, CA 92656-3317). Chaque goutte est faite en ajoutant respectivement 2 µl du mélange protéine-solutés décrit ci-dessus, 0,4 µl du calix[4]arène préparé préalablement à une concentration 10X et neutralisé à pH 8,0, et 1,6 µl d'une solution 0,2M LiNO₃ / 22% PEG 2000 MME. Le réservoir de chaque puits est rempli avec 500 µl de cette solution. Les plaques sont ensuite stockées à 18°C. Les gouttes sont photographiées avec une loupe SV11 (Zeiss) et un système d'acquisition CCD 1,4 Mp, et analysés avec le logiciel Zeiss vision image. Les cristaux sont prélevés, lavés dans la solution de réservoir et montés sur boucle cryo (Hampton res.), puis congelés et conservés dans l'azote liquide. Les cristaux sont analysés à l'ESRF, sur la ligne microfocus ID23-2 et les clichés de diffraction générés par un détecteur ADSC Quantum 315R CCD.

Les conditions décrites dans cet exemple sont les conditions standards de cristallisation de H₆BmrA et sont celles utilisées pour les exemples 3 à 7.

### Exemple 3 : Essais de cristallisation sans additifs (témoin)

En absence de calix[4]arène, les conditions standard de cristallisation de H₆*B*mrA permettent d'obtenir des cristaux de protéines typiquement en 3 semaines. De fait après 2 jours d'incubation à 18°C, aucun cristal n'est visible dans la goutte correspondante, tel que l'on peut le voir dans le panneau de la Figure 3A, à gauche.

### Exemple 4 : Essais de cristallisation avec additifs

La présence des calix *p*(HOOC)₃Ar4 *o*X dans les différents essais montre dans les mêmes conditions la présence de nombreux cristaux, bien formés et très grands, obtenus en seulement 2 jours (figure 3). Les calix[4]arènes ayant les chaînes aliphatiques les plus courtes produisent les meilleurs effets.

Les mêmes conditions sont testées pendant 10 jours (figure 4), ce qui permet de voir apparaître des cristaux dans les gouttes comportant les dérivés calixarèniques les plus longs, alors qu'ils ne sont toujours pas formés en leur absence.

### Exemple 5 : Essais de cristallisation sans protéines (contrôle)

La possibilité existe que les cristaux ne soient pas ceux produits avec H₆BmrA mais avec les dérivés calixarèniques eux-mêmes. Pour se faire, les mêmes conditions de cristallisations ont été reproduites, cette fois sans ajouter de protéine. La figure 5 montre qu'aucun cristal n'apparaît. Il s'agit donc bien de cristaux de nature protéique qui sont obtenus dans les exemples précédents.

### Exemple 6 : Reconstitution fonctionnelle de H₆BmrA après traitement avec p(HOOC)₃Ar4 o((CH₂)₆CH₃) ("C4C7")

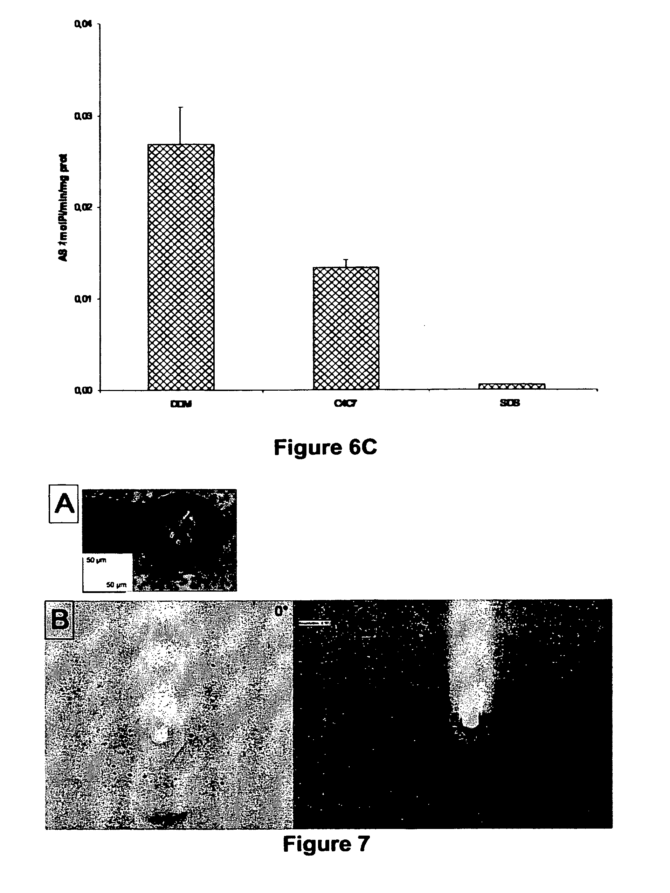

Les dérivés calixarèniques utilisés dans la présente invention ne sont pas délétères pour l'activité enzymatique de la protéine H₆*B*mrA. Ceci est illustré avec le dérivé *p*(HOOC)₃Ar4 *o*((CH₂)₆CH₃), qui a une activité surfactante et permet l'extraction de la protéine. Comme montré dans la figure 6, la protéine conserve son activité après la phase d'extraction/reconstitution, comme avec un détergent doux du type dodécyl maltoside (DDM). À l'inverse, l'utilisation de dodécyl sulfate de sodium (SDS), un détergent dénaturant utilisé pour déplier les protéines, ne permet pas une reconstitution fonctionnelle.

### Exemple 7 : Test au synchrotron de l'ESRF (European Synchrotron Radiation Facility) du cristal de H₆BmrA en présence de p(HOOC)₃Ar4 o((CH₂)₂CH₃)

Certains des cristaux qui ont été produits dans la figure 3 ont été testés au synchrotron de l'ESRF sur la ligne microfocus ID23-2 et les clichés de diffraction générés par un détecteur ADSC Quantum 315R CCD. Comme illustré dans la figure 7, l'un d'eux a permis d'obtenir un cliché de diffraction typique d'une protéine, avec une indexation compatible avec un cristal monoclinique de maille : a = 56 Å, b = 254 Å, c = 128 Å, alpha = 90°, beta = 108°, gamma = 90°.

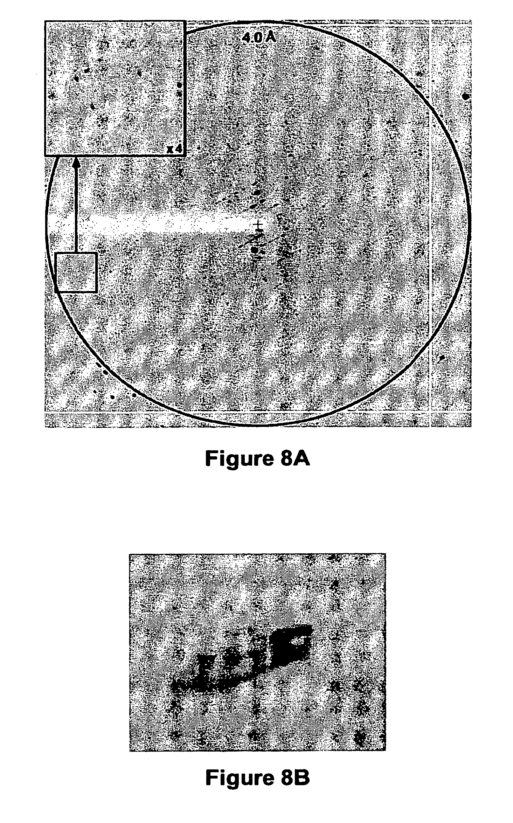

La même expérience a été réalisée sur la ligne microfocus ID23-1. La figure 8 présente un cliché de diffraction du cristal de H₆BmrA obtenu.

### Exemple 8 : Exemple d'un kit de cristallisation

On réalise un kit de cristallisation comprenant une solution comprenant au moins un dérivé calixarènique défini ci-dessus.

Ce kit peut comprendre en outre une notice d'utilisation, un tampon de lavage approprié, ou tout autre solution ou dispositif approprié ou une combinaison de ces éléments.

Ces expérimentations démontrent que la présente invention est très performante pour la cristallisation des molécules polaires et/ou chargées positivement, notamment des protéines membranaires.

La présente invention forme donc un outil remarquable, notamment pour la détermination structurale à l'échelle atomique de ces molécules.

### Listes des références

1. Caffrey M. (2003) Membrane protein crystallization. J Struct Biol 142, 108-32.
2. Garavito R. M. and Ferguson-Miller S. (2001) Detergents as Tools in Membrane Biochemistry. J Biol Chem 276, 32403-6.
3. Nollert P. (2005) Membrane protein crystallization in amphiphile phases: practical and theoretical considerations. Prog Biophys Mol Biol 88, 339-57.
4. Lundstrom K. (2004) Structural genomics on membrane proteins: the MePNet approach. Curr Opin Drug Discov Devel 7, 342-6.
5. Dean M., Hamon Y. and Chimini G. (2001) The human ATP-binding cassette (ABC) transporter superfamily. J Lipid Res 42, 1007-17.
6. Efferth T. (2003) Adenosine triphosphate-binding cassette transporter genes in ageing and age-related diseases. Ageing Res Rev 2, 11-24.
7. Kim R. B. (2003) Drug transporters in HIV Therapy. Top HIV Med 11, 136-9.
8. Rajagopal A. and Simon S. M. (2003) Subcellular localization and activity of multidrug résistance proteins. Mol Biol Cell 14, 3389-99.
9. Boumendjel A., Baubichon-Cortay H., Trompier D., Perrotton T. and Di Pietro A. (2005) Anticancer multidrug résistance mediated by MRP1: recent advances in the discovery of reversal agents. Med Res Rev 25, 453-72.
10. Frelet A. and Klein M. (2006) Insight in eukaryotic ABC transporter function by mutation analysis. FEBS Lett 580, 1064-84.
11. Shirasaka Y., Onishi Y., Sakurai A., Nakagawa H., Ishikawa T. and Yamashita S. (2006) Evaluation of Human P-Glycoprotein (MDR1/ABCB1) ATPase Activity Assay Method by Comparing with in Vitro Transport Measurements: Michaelis-Menten Kinetic Analysis to Estimate the Affinity of P-Glycoprotein to Drugs. Biol Pharm Bull 29, 2465-71.
12. Szakacs G., Paterson J. K., Ludwig J. A., Booth-Genthe C. and Gottesman M. M. (2006) Targeting multidrug résistance in cancer. Nat Rev Drug Discov 5, 219-34.
13. Enokizono J., Kusuhara H., Ose A., Schinkel A. H. and Sugiyama Y. (2008) Quantitative Investigation of the Role of Breast Cancer Resistance Protein (Bcrp/Abcg2) in Limiting Brain and Testis Pénétration of Xenobiotic Compounds. Drug Metab Dispos, dmd.107.019257.
14. McPherson A. and Cudney B. (2006) Searching for silver bullets: an alternative strategy for crystallizing macromolecules. J Struct Biol 156, 387-406.
15. Chami M., Steinfels E., Orelle C., Jault J. M., Di Pietro A., Rigaud J. L. and Marco S. (2002) Three-dimensional structure by cryo-electron microscopy of YvcC, an homodimeric ATP-binding cassette transporter from Bacillus subtilis. J Mol Biol 315, 1075-85.
16. Smith P. K., Krohn R. I., Hermanson G. T., Mallia A. K., Gartner F. H., Provenzano M. D., Fujimoto E. K., Goeke N. M., Olson B. J. and Klenk D. C. (1985) Measurement of protein using bicinchoninic acid. Anal Biochem 150, 76-85.
17. Laemmli U. K. (1970) Cleavage of structural proteins during the assembly of the head of bacteriophage T4. Nature 227, 680-5.
18. Lenoir G., Menguy T., Corre F., Montigny C., Pedersen P. A., Thinès D., le Maire M. and Falson P. (2002) Overproduction in yeast and rapid and efficient purification of the rabbit SERCA1a Ca2+-ATPase. Biochim Biophys Acta 1560, 67-83.

### SEQUENCE LISTING

<110> Centre National de la recherche scientifique (CNRS) Falson, Pierre Coleman, Anthony Matar, Rima Leydier, Antoine Huche, FÈdÈric
<120> Promoteur de la cristallisation de protÈines
<130> BIP133389PC00
<150> FR 09/01678
   <151> 2009-04-06
<160> 2
<170> PatentIn version 3.5
<210> 1
   <211> 589
   <212> PRT
   <213> Bacillus subtilis
<400> 1

## Revendications

1. Utilisation d'au moins un dérivé calix[n]arènique répondant à la formule (I) suivante : 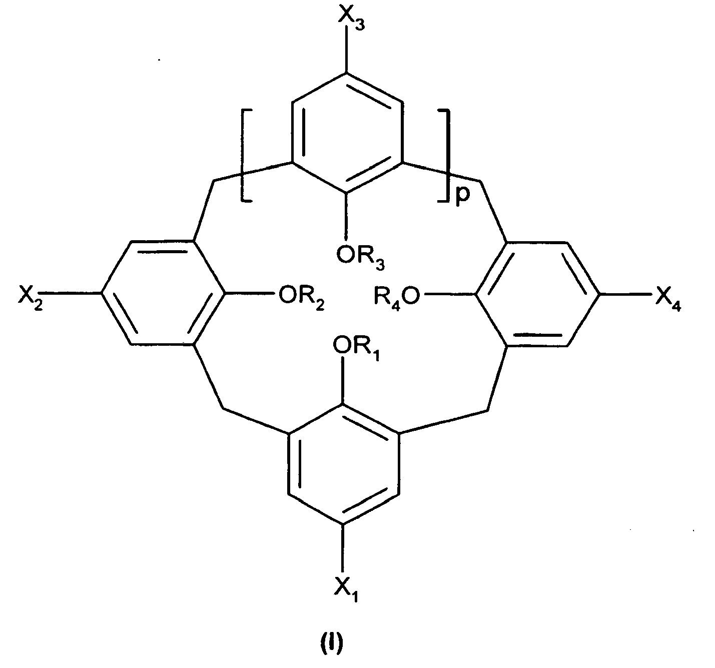 dans laquelle :
■ p est un nombre entier allant de 1 à 9 ;
■ R¹, R², R³ et R⁴ représentent, indépendamment les uns des autres, un hydrogène, un groupe - (CₘH₂ₘ₊₁) ou un groupe alcène, linéaire ou ramifié, dans lequel m est un nombre entier allant de 1 à 12 ou valant 16 ou 18 ;
■ X¹, X², X³ et X⁴ représentent, indépendamment les uns des autres, un atome d'hydrogène, un groupe carboxylique ou un groupe -(CH₂)_{y}-COOH dans lequel y est un nombre entier allant de 1 à 12, ou un acide benzoïque,
en tant qu'additif de cristallisation d'une molécule polaire et/ou chargée positivement choisie dans le groupe comprenant les protéines, les peptides, les complexes protéiques, les domaines protéiques, les glycoprotéines, les phosphoglycoprotéines.

2. Utilisation selon la revendication 1, dans laquelle l'au moins un dérivé calix[n]arènique répond à la formule (I) dans laquelle :
■ p est un nombre entier égal à 1
■ un radical parmi R¹, R², R³ et R⁴ représente un groupe - (CₘH₂ₘ₊₁) linéaire ou ramifié dans lequel m est un nombre entier compris entre 1 à 12 inclus ou valant 16 ou 18 ;
■ trois radicaux parmi R¹, R², R³ et R⁴ représentent un atome d'hydrogène
;
■ un radical parmi X¹, X², X³ et X⁴ représente un atome d'hydrogène ;
■ trois radicaux parmi X¹, X², X³ ou X⁴ représentent, un groupe carboxylique ou un groupe -(CH₂)_{y}-COOH dans lequel y est un nombre entier allant de 1 à 12.

3. Utilisation selon la revendication 1 ou 2, dans laquelle le groupe - (CₘH₂ₘ₊₁) est choisi dans le groupe comprenant le groupe méthyle, éthyle, propyle, butyle, pentyle, hexyle, heptyle, octyle, nonyle, decyle, undécyle et dodécyle.

4. Utilisation selon l'une quelconque des revendications 1 à 3, dans laquelle la molécule polaire et/ou chargée positivement est une protéine membranaire ou une protéine soluble, entière ou des fragments ou domaines de celles-ci.

5. Utilisation selon l'une quelconque des revendications 1 à 4, dans laquelle la molécule polaire et/ou chargée positivement est choisie dans le groupe comprenant les récepteurs à protéines G, les canaux, les symporteurs, les antiporteurs, les transporteurs d'électrons, de protons, les pompes à anions, les pompes à cations, à métaux, à peptides, les pompes d'efflux du type BmrA.

6. Procédé de cristallisation d'une molécule polaire et/ou chargée positivement choisie dans le groupe comprenant les protéines, les peptides, les complexes protéiques, les domaines protéiques, les glycoprotéines, les phosphoglycoprotéines, comprenant une étape de mise en contact :
a. d'une solution aqueuse comprenant une molécule à cristalliser et au moins un dérivé calix[n]arènique répondant à la formule (I) suivante : 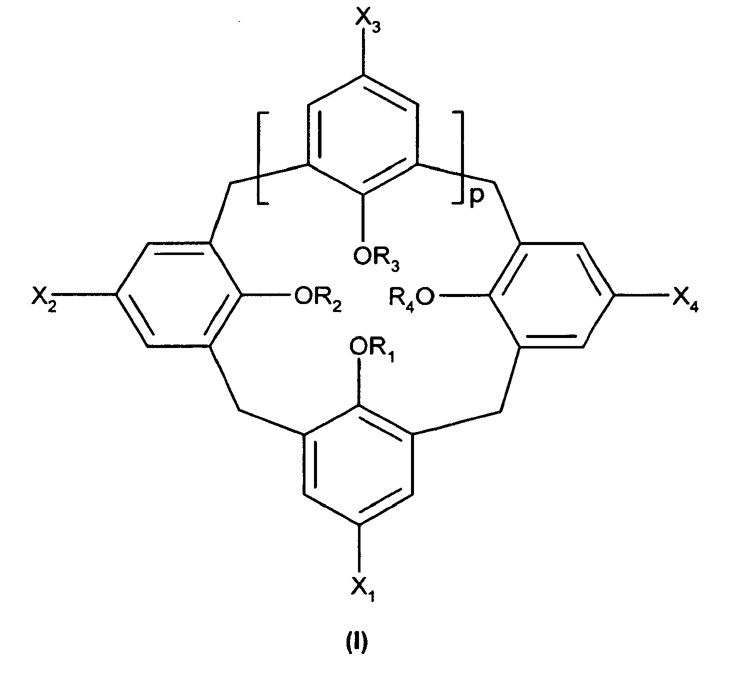 dans laquelle :
■ p est égal à 1,3, 5, 6. ;
■ R¹, R², R³, R⁴ représentent, indépendamment les uns des autres un hydrogène, un groupe - (CₘH₂ₘ₊₁) ou un groupe alcène, linéaire ou ramifié, dans lequel m est un nombre entier allant de 1 à 12 ou valant 16 ou 18 ;
■ X¹, X², X³ et X⁴ représentent, indépendamment les uns des autres, un atome d'hydrogène, un groupe carboxylique ou un groupe -(CH₂)_{y}-COOH dans lequel y est un nombre entier allant de 1 à 12, ou un acide benzoïque.

7. Procédé selon la revendication 6, dans lequel l'au moins un dérivé calix[n]arènique répond à la formule (I) dans laquelle :
■ p est un nombre entier égal à 1
■ un radical parmi R¹, R², R³ et R⁴ représente un groupe - (CₘH₂ₘ₊₁) linéaire ou ramifié dans lequel m est un nombre entier compris entre 1 à 12 inclus ou valant 16 ou 18 ;
■ trois radicaux parmi R¹, R², R³ et R⁴ représentent un atome d'hydrogène
;
■ un radical parmi X¹, X², X³ et X⁴ représente un atome d'hydrogène ;
■ trois radicaux parmi X¹, X², X³ ou X⁴ représentent, un groupe carboxylique ou un groupe -(CH₂)_{y}-COOH dans lequel y est un nombre entier allant de 1 à 12.

8. Procédé selon la revendication 6 ou 7, dans lequel le groupe - (CₘH₂ₘ₊₁) est choisi dans le groupe comprenant le groupe méthyle, éthyle, propyle, butyle, pentyle, hexyle, heptyle, octyle, nonyle, decyle, undécyle et dodécyle.

9. Procédé selon l'une quelconque des revendications 6 à 8, dans laquelle la molécule polaire et/ou chargée positivement est une protéine membranaire ou soluble.

10. Procédé selon l'une quelconque des revendications 6 à 9, dans lequel la molécule polaire et/ou chargée positivement est choisie dans le groupe comprenant les récepteurs à protéines G, les canaux, les symporteurs, les antiporteurs, les transporteurs d'électrons, de protons, les pompes à anions, les pompes à cations, à métaux, à peptides, les pompes d'efflux du type BmrA.

11. Procédé selon l'une quelconque des revendications 6 à 10, dans lequel la mise en contact est réalisée à un pH compris entre 5,0 et 14.

12. Procédé selon l'une quelconque des revendications 6 à 11 dans lequel la mise en contact est réalisée à une température comprise entre -40°C et 80 °C.

13. Procédé selon l'une quelconque des revendications 6 à 12, dans lequel la mise en contact est réalisée à une concentration en calixarène comprise entre 1 nM et 100 mM.

## Patentansprüche

1. Verwendung von mindestens einem Calix[n]aren-Derivat der nachstehenden Formel (I): 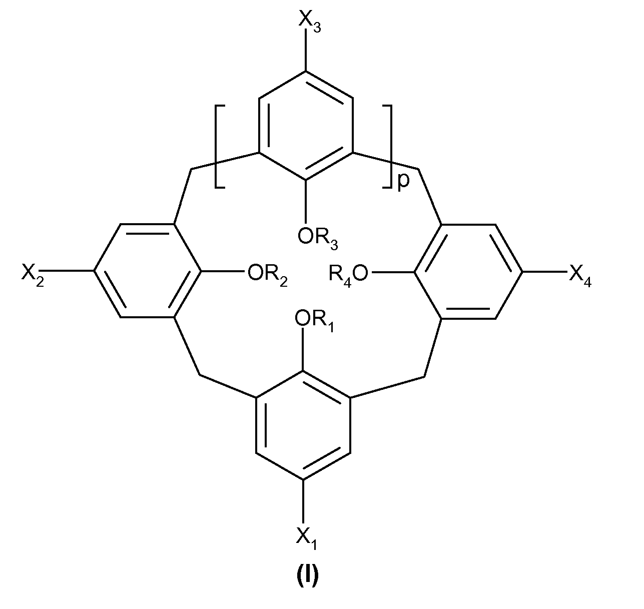 worin:
■ p eine ganze Zahl von 1 bis 9 ist;
■ R¹, R², R³ und R⁴ unabhängig voneinander für ein Wasserstoffatom, eine Gruppe - (CₘH₂ₘ₊₁) oder eine gerade oder verzweigte Alkengruppe stehen, wobei m eine ganze Zahl von 1 bis 12 oder mit dem Wert 16 oder 18 ist;
■ X¹, X², X³ und X⁴ unabhängig voneinander für ein Wasserstoffatom, eine Carboxylgruppe oder eine Gruppe - (CH₂)_{y}-COOH, wobei y eine ganze Zahl von 1 bis 12 ist, oder eine Benzoesäure stehen,
als Kristallisationshilfsstoff für ein polares und/oder positiv geladenes Molekül, ausgewählt aus der Gruppe, die Proteine, Peptide, Proteinkomplexe, Proteindomänen, Glykoproteine, Phosphoglykoproteine umfasst.

2. Verwendung nach Anspruch 1, wobei das mindestens eine Calix[n]aren-Derivat der Formel (I) entspricht, worin:
■ p eine ganze Zahl gleich 1 ist;
■ ein Rest aus R¹, R², R³ und R⁴ für eine gerade oder verzweigte Gruppe - (CₘH₂ₘ₊₁) steht, wobei m eine ganze Zahl von 1 bis einschließlich 12 oder mit dem Wert 16 oder 18 ist;
■ drei Reste aus R¹ R² R³ und R⁴ für ein Wasserstoffatom stehen;
■ ein Rest aus X¹, X², X³ und X⁴ für ein Wasserstoffatom steht,
■ drei Reste aus X¹, X², X³ und X⁴ für eine Carboxylgruppe oder eine Gruppe -(CH₂)_{y}-COOH stehen, wobei y eine ganze Zahl von 1 bis 12 ist.

3. Verwendung nach Anspruch 1 oder 2, wobei die Gruppe - (CₘH₂ₘ₊₁) wird aus der Gruppe ausgewählt wird, umfassend eine Methyl-, Ethyl-, Propyl-, Butyl-, Pentyl-, Hexyl-, Heptyl-, Octyl-, Nonyl-, Decyl-, Undecyl- und Dodecylgruppe.

4. Verwendung nach einem der Ansprüche 1 bis 3, wobei das polare und/oder positive geladene Molekül ein Membranprotein oder ein lösliches Protein im Ganzen oder Fragmente oder Domänen davon ist.

5. Verwendung nach einem der Ansprüche 1 bis 4, wobei das polare und/oder positiv geladene Molekül aus der Gruppe ausgewählt ist, umfassend G-Protein-Rezeptoren, Kanäle, Symporter, Antiporter, Elektronentransporter, Protonentransporter, Anionenpumpen, Kationenpumpen, Metallionenpumpen, Peptidpumpen und Effluxpumpen des Typs BmrA.

6. Verfahren zur Kristallisation eines polaren und/oder positiv geladenen Moleküls, ausgewählt aus der Gruppe, die Proteine, Peptide, Proteinkomplexe, Proteindomänen, Glykoproteine, Phosphoglykoproteine umfasst, umfassend einen Schritt des In-Kontakt-Bringens:
a. einer wässrige Lösung, die ein zu kristallisierendes Molekül umfasst, und
mindestens eines Calix[n]aren-Derivats der nachstehenden Formel (I): 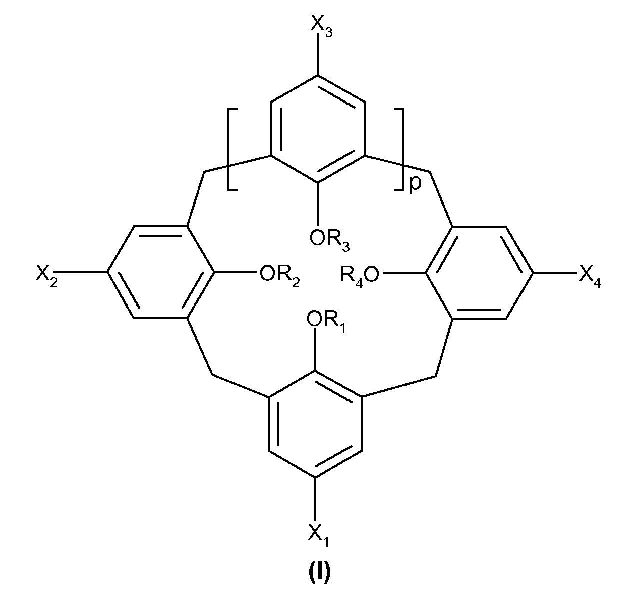 worin:
■ p gleich 1, 3, 5, 6 ist;
■ R¹, R², R³, R⁴ unabhängig voneinander für ein Wasserstoffatom, eine Gruppe - (CₘH₂ₘ₊₁) oder eine gerade oder verzweigte Alkengruppe stehen, wobei m eine ganze Zahl von 1 bis 12 oder mit dem Wert 16 oder 18 ist;
■ X¹, X², X³ und X⁴ unabhängig voneinander für ein Wasserstoffatom, eine Carboxylgruppe oder eine Gruppe - (CH₂)_{y}-COOH, wobei y eine ganze Zahl von 1 bis 12 ist, oder eine Benzoesäure stehen.

7. Verfahren nach Anspruch 6, wobei das mindestens eine Calix[n]aren-Derivat der Formel (I) entspricht, worin:
■ p eine ganze Zahl gleich 1 ist;
■ ein Rest aus R¹, R², R³ und R⁴ für eine gerade oder verzweigte Gruppe - (CₘH₂ₘ₊₁) steht, wobei m eine ganze Zahl von 1 bis einschließlich 12 oder mit dem Wert 16 oder 18 ist;
■ drei Reste aus R¹, R² R³ und R⁴ für ein Wasserstoffatom stehen;
■ ein Rest aus X¹, X², X³ und X⁴ für ein Wasserstoffatom steht,
■ drei Reste aus X¹, X², X³ und X⁴ für eine Carboxylgruppe oder eine Gruppe -(CH₂)_{y}-COOH stehen, wobei y eine ganze Zahl von 1 bis 12 ist.

8. Verfahren nach Anspruch 6 oder 7, wobei die Gruppe - (CₘH₂ₘ₊₁) aus der Gruppe ausgewählt wird, umfassend eine Methyl-, Ethyl-, Propyl-, Butyl-, Pentyl-, Hexyl-, Heptyl-, Octyl-, Nonyl-, Decyl-, Undecyl- und Dodecylgruppe.

9. Verfahren nach einem der Ansprüche 6 bis 8, wobei das polare und/oder positive geladene Molekül ein Membranprotein oder ein lösliches Protein ist.

10. Verfahren nach einem der Ansprüche 6 bis 9, wobei das polare und/oder positiv geladene Molekül aus der Gruppe ausgewählt ist, umfassend G-Protein-Rezeptoren, Kanäle, Symporter, Antiporter, Elektronentransporter, Protonentransporter, Anionenpumpen, Kationenpumpen, Metallionenpumpen, Peptidpumpen und Effluxpumpen des Typs BmrA.

11. Verfahren nach einem der Ansprüche 6 bis 10, wobei das In-Kontakt-Bringen bei einem pH zwischen 5,0 und 14 durchgeführt wird.

12. Verfahren nach einem der Ansprüche 6 bis 11, wobei das In-Kontakt-Bringen bei einer Temperatur zwischen -40 °C und 80 °C durchgeführt wird.

13. Verfahren einem der Ansprüche 6 bis 12, wobei das In-Kontakt-Bringen bei einer Konzentration an Calixaren zwischen 1 nM und 100 mM durchgeführt wird.

## Claims

1. A use of at least one calix[n]arene derivative corresponding to formula (I) below: 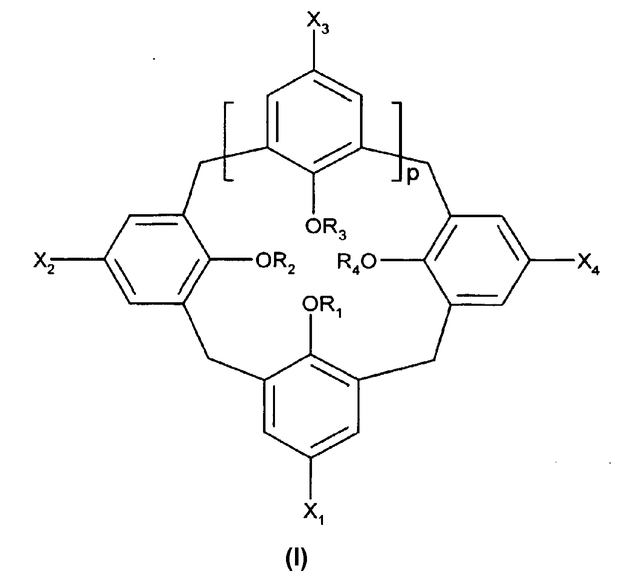 wherein:
■ p is an integer ranging from 1 to 9;
■ R¹, R², R³ and R⁴ represent, independently of each other, a hydrogen, a group -(CₘH₂ₘ₊₁) or a linear or branched alkene group, wherein m is an integer ranging from 1 to 12 or equal to 16 or 18;
■ X¹, X², X³ and X⁴ represent, independently of each other, a hydrogen atom, a carboxylic group or a group -(CH₂)_{y}-COOH wherein y is an integer ranging from 1 to 12, or a benzoic acid,
as an additive for the crystallization of a polar and/or positively charged molecule chosen from the group comprising proteins, peptides, protein complexes, protein domains, glycoproteins and phosphoglycoproteins.

2. The use according to claim 1, wherein the at least one calix[n]arene derivative corresponds to formula (I) wherein:
■ p is an integer equal to 1;
■ a radical from among R¹, R², R³ and R⁴ represents a linear or branched group -(CₘH₂ₘ₊₁) wherein m is an integer between 1 and 12 inclusive or is equal to 16 or 18;
■ three radicals from among R¹, R², R³ and R⁴ represent a hydrogen atom;
■ one radical from among X¹, X², X³ and X⁴ represents a hydrogen atom;
■ three radicals from among X¹, X², X³ and X⁴ represent a carboxylic group or a group -(CH₂)_{y}-COOH wherein y is an integer ranging from 1 to 12.

3. The use according to claim 1 or 2, wherein the group -(CₘH2ₘ₊₁) is chosen from the group comprising methyl, ethyl, propyl, butyl, pentyl, hexyl, heptyl, octyl, nonyl, decyl, undecyl and dodecyl groups.

4. The use according to anyone of claims 1 to 3, wherein the polar and/or positively charged molecule is a membrane protein or a soluble protein, in whole form or fragments or domains thereof.

5. The use according to anyone of claims 1 to 4, wherein the polar and/or positively charged molecule is chosen from the group comprising protein G receptors, channels, symporters, antiporters, electron transporters, protons, anion pumps, cation pumps, metal pumps, peptide pumps and efflux pumps of BmrA type.

6. A process for the crystallization of a polar and/or positively charged molecule chosen from the group comprising proteins, peptides, protein complexes, protein domains, glycoproteins and phosphoglycoproteins, comprising a step of placing in contact:
a. an aqueous solution comprising a molecule to be crystallized and
at least one calix[n]arene derivative corresponding to formula (I) below: 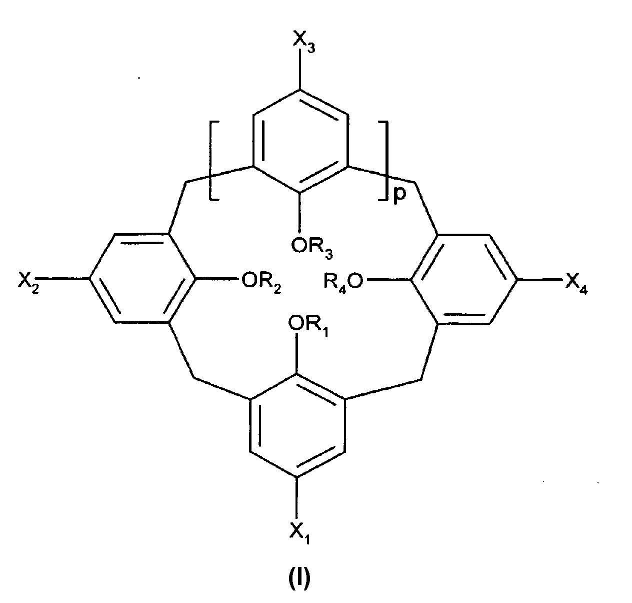 wherein:
■ p is equal to 1, 3, 5 or 6;
■ R¹, R², R³ and R⁴ represent, independently of each other, a hydrogen, a group -(CₘH₂ₘ₊₁) or a linear or branched alkene group, wherein m is an integer ranging from 1 to 12 or is equal to 16 or 18;
■ X¹, X², X³ and X⁴ represent, independently of each other, a hydrogen atom, a carboxylic group or a group -(CH₂)_{y}-COOH wherein y is an integer ranging from 1 to 12, or a benzoic acid.

7. The process according to claim 6, wherein the at least one calix[n]arene derivative corresponds to formula (I) wherein:
■ p is an integer equal to 1;
■ one radical from among R¹, R², R³ and R⁴ represents a linear or branched group -(CₘH₂ₘ₊₁) wherein m is an integer between 1 and 12 inclusive or is equal to 16 or 18;
■ three radicals from among R¹, R², R³ and R⁴ represent a hydrogen atom;
■ one radical from among X¹, X², X³ and X⁴ represents a hydrogen atom;
■ three radicals from among X¹, X², X³ and X⁴ represent a carboxylic group or a group -(CH₂)_{y}-COOH wherein y is an integer ranging from 1 to 12.

8. The process according to claim 6 or 7, wherein the group -(CₘH₂ₘ₊₁) is chosen from the group comprising methyl, ethyl, propyl, butyl, pentyl, hexyl, heptyl, octyl, nonyl, decyl, undecyl and dodecyl groups.

9. The process according to anyone of claims 6 to 8, wherein the polar and/or positively charged molecule is a membrane protein or a soluble protein.

10. The process according to anyone of claims 6 to 9, wherein the polar and/or positively charged molecule is chosen from the group comprising protein G receptors, channels, symporters, antiporters, electron transporters, protons, anion pumps, cation pumps, metal pumps, peptide pumps and efflux pumps of the BmrA type.

11. The process according to anyone of claims 6 to 10, wherein the placing in contact is performed at a pH of between 5.0 and 14.

12. The process according to anyone of claims 6 to 11, wherein the placing in contact is performed at a temperature of between - 40°C and 80°C.

13. The process according to anyone of claims 6 to 12, wherein the placing in contact is performed at a calixarene concentration of between 1 nM and 100 mM.
